# EUROPEAN PATENT APPLICATION

(11) **EP 2 592 657 A1**
(43) Date of publication of application: **15.05.2013**
(21) Application number: 11803652.4
(22) Date of filing: 07.07.2011
(51) Int. Cl.: H01L 31/04, H01L 31/042

(54) **SOLAR CELL MODULE AND METHOD FOR MANUFACTURING SOLAR CELL MODULE**

(30) Priority: 08.07.2010 JP 2010155758
(71) Applicant: Dexerials Corporation, Tokyo 141-0032 (JP)
(72) Inventor: HANAI, Daisuke, Osaki, Shinagawa-ku Tokyo 1410032 (JP)
(74) Representative: Müller - Hoffmann & Partner
(86) International application number: PCT/JP2011/065546
(87) International publication number: WO 2012/005318

(57) **Abstract**

Disclosed is a solar cell module wherein an adhesive property between a back surface electrode and a tab lead is improved via an electroconductive adhesive film, and also a power generation efficiency is improved. The solar cell module comprises: a plurality of silicon cell substrates (2), each having a front surface electrode provided at a side of a light incident surface and having an Al back surface electrode (13) provided on a back surface; a tab lead (3) configured to connect the front surface electrode (11) to the Al back surface electrode (13); and electroconductive adhesive layers (20) configured to connect the tab lead (3) to each of the front surface electrode (11) and the Al back surface electrode (13), respectively. In the Al back surface electrode (13), an opening portion (31) is formed in a connecting portion (30) to the tab lead (3), the opening portion to expose a silicon surface of the silicon cell substrate (2) being provided to be narrower than the tab lead (3) and than the electroconductive adhesive layer (20), and being linearly formed along with the connecting portion (30). The tab lead (3) is bonded, via the electroconductive adhesive layer (20), to the silicon surface of the silicon cell substrate (2) which is exposed via the opening portion (31), while is also bonded to the Al back surface electrode (13).

## Description

### Field of the Invention

The present invention relates to a solar cell module in which electrodes for connection of a plurality of solar cells are connected by tab leads, and a method for manufacturing the solar cell module.
The present application asserts priority rights based on JP Patent Application 2010-155758 filed in Japan on July 8, 2010. The total contents of disclosure of the Patent Application of the senior filing date are to be incorporated by reference into the present Application.

### Background of the Invention

Solar cells can directly convert sunlight, which is a clean and inexhaustible energy source, into electricity, and therefore have attracted attention as an environmentally friendly new energy source. When solar cells are used as a power source, the output per solar cell is approximately several watts, and accordingly, solar cells are not used independently, but, a plurality of solar cells are connected in series, thereby being used as a solar cell module in which the output is increased to not less than 100 W.

For example, in a crystalline silicon solar cell module, a plurality of solar cells which adjoin each other are connected by a tab lead made of a solder-plated ribbon-shaped copper foil. One end portion of the tab lead is connected to a front surface electrode of a solar cell, while the other end portion of the tab lead is connected to a back surface electrode of another solar cell adjoining said solar cell, and thus each of solar cells is connected in series.

Specifically, a solar cell and a tab lead is connected in such a manner that each of a bus bar electrode formed in a light incident surface of a solar cell by screen printing of silver paste and an Ag electrode formed in a connecting portion in a back surface of another solar cell is connected to a tab lead, respectively, by soldering (PTL 1). Note that, in an area other than the connecting portion of the back surface of the solar cell, an Al electrode is formed.

However, connection by soldering is performed at a high temperature of approximately 260 degrees C, and therefore, due to a warp of a solar cell, internal stress produced in a connecting portion of a tab lead to each of front and back surface electrodes, furthermore, a residue of a flux, and the like, there is a concern about the possibility that connection reliability between the tab lead and each of the front and back surface electrodes of the solar cell is reduced.

Then, for connection between each of front and back surface electrodes of a solar cell and a tab lead, an electroconductive adhesive film which is connectable by thermocompression-bonding at a comparatively low temperature has been conventionally used (PTL 2). As such electroconductive adhesive film, there has been used a film which is obtained in such a manner that electroconductive particles having an average particle diameter of the order of several µm and having a spherical or scale shape are dispersed in a heat-curing type binder resin composite to produce a film.

### Prior-Art Documents

### Patent Document

PTL 1: Japanese Patent Application Laid-Open No. 2004-356349
PTL 2: Japanese Patent Application Laid-Open No. 2008-135654

### Summary of the Invention

In the case where a solar cell of such crystalline silicon solar cell module is connected using an electroconductive adhesive film, a Si surface of the solar cell composed of a silicon substrate is firmly bonded to an electroconductive adhesive film, and therefore there is no problem with connection between a front surface electrode and a tab lead. On the other hand, the strength of an Al electrode itself which is formed in an area other than a connecting portion on a back surface of the cell is not high, and accordingly the bonding strength between the solar cell and the tab lead is not so high.

A back surface electrode on the back surface of the cell and a tab lead are connected by heating the tab lead by applying a pressure of approximately 0.5 to 3 MPa onto the back surface electrode via an electroconductive adhesive film, and a pressure of a several hundred N is applied to one piece of silicon substrate. Here, for crystalline silicon solar cells, there has been a task of procuring silicon used as a raw material inexpensively and in large quantities, and, in recent years, ultrathin silicon wafers (for example, 200 µm to 150 µm) have started to be cut out from a polycrystal silicon ingot and used for mass production. Therefore, the strength of the silicon substrates is not necessarily high strength, and the silicon substrates need to be hot-pressed at a low pressure in order to prevent breakages.

However, it is feared that, in the conventional solar cell modules, when a tab lead is hot-pressed at a low pressure, connection reliability to an Ag electrode formed in connecting portions of back and frond surfaces could be reduced.

Note that the bonding strength of an electroconductive adhesive film with respect to an Al electrode is not sufficient. By forming an Al electrode in an area other than a connecting portion in a back surface of a solar cell, and in addition, by providing an Ag electrode in the connecting portion, the bonding strength to the electroconductive adhesive film can be increased. However, in such method for securing the connection reliability of a tab lead to a back surface electrode, from the above-mentioned reason, an Ag electrode needs to be provided in a connecting portion, which leads increase in the number of parts and increase in the number of manufacturing man-hours and cost, whereby it becomes difficult to supply solar cell modules inexpensively and in large quantities.

Therefore, the present invention aims at providing a solar cell module and a method for manufacturing the solar cell module, wherein, by hot-pressing at a low pressure, the solar cell is prevented from being damaged, while, particularly, a adhesive property between a back surface electrode provided in a back surface of the solar cell and an electroconductive adhesive film, and power generation efficiency are improved.

In order to solve the above-mentioned problems, a solar cell module according to the present invention comprises a plurality of silicon cell substrates each being configured such that a front surface electrode is provided at a side of a light incident surface while an Al back surface electrode is provided on a back surface at a side opposite to the light incident surface; a tab lead configured to connect the front surface electrode of one of the silicon cell substrates and the Al back surface electrode of another one of the silicon cell substrates adjoining said silicon cell substrate; and an electroconductive adhesive layer configured to connect each of the front surface electrode and the Al back surface electrode to the tab lead, respectively, wherein, in the Al back surface electrode, an opening portion to expose the silicon surface of the silicon cell substrate is formed in a connecting portion to the tab lead, the opening portion being provided to be narrower than the tab lead and than the electroconductive adhesive layer, and being linearly formed along with the connecting portion, and the tab lead is bonded, via the electroconductive adhesive layer, to the silicon surface of the silicon cell substrate which is exposed via the opening portion, while is also bonded to the Al back surface electrode.

In a method for manufacturing a solar cell module according to the present invention, wherein the solar cell module includes a plurality of silicon cell substrates each being configured such that a front surface electrode is provided on a side of a light incident surface while an Al back surface electrode is provided on a back surface at a side opposite to the light incident surface, and includes a tab lead configured to connect, via an electroconductive adhesive layer, the front surface electrode of one of the silicon cell substrates and the Al back surface electrode of another one of the silicon cell substrates adjoining said silicon cell substrate; the method comprises the steps of: laminating the electroconductive adhesive layer in a opening portion to expose a silicon surface of the silicon cell substrate which is linearly provided in a connecting portion to the tab lead in the Al back surface electrode along with said connecting portion and is narrower than the tab lead and than the electroconductive adhesive layer; and laminating one end of the tab lead on the electroconductive adhesive layer.

### Effects of Invention

According to the present invention, when an Al back surface electrode and a tab lead are connected via an electroconductive adhesive layer, an opening portion is provided in a connecting portion to the tab lead to expose a Si surface, whereby the electroconductive adhesive layer and the Si surface are better connected. Also, the periphery of the opening portion and the tab lead are connected, whereby the tab lead and the Al surface back electrode are electrically connected. Furthermore, because of forming the opening portion, pressure at the time of hot-pressing concentrates on an area other than the opening portion, whereby, even at a low pressure, the tab lead is firmly connected also to the area other than the opening portion in a connecting portion.

### Brief Description of Drawings

Figure 1 is an exploded perspective view of a solar cell module according to the present invention.
Figure 2 is a cross-sectional view of a solar cell.
Figure 3 is a bottom plan view showing an Al back surface electrode of a solar cell according to the present invention.
Figure 4 is a bottom plan view showing an Al back surface electrode of a solar cell according to the present invention, wherein a tab lead is connected thereto.
Figure 5 is a cross-sectional view showing a connecting portion of a solar cell according to the present invention.
Figure 6 is a plan view showing a connecting portion of a solar cell according to the present invention.
Figure 7 is a plan view showing a connecting portion of a solar cell according to the present invention.
Figure 8 is a cross-sectional view showing a connecting portion of a solar cell according to the present invention.
Figure 9 is a plan view showing a connecting portion of a solar cell according to the present invention.
Figure 10 is a cross-sectional view showing a connecting portion of a solar cell according to the present invention.
Figure 11 is a cross-sectional view showing a connecting portion of a solar cell according to the present invention.
Figure 12 is a cross-sectional view showing a connecting portion of a solar cell according to the present invention.
Figure 13 is a cross-sectional view showing a composition of an electroconductive adhesive film.
Figure 14 is a drawing showing an electroconductive adhesive film.

### Detailed Description of the Invention

Hereinafter, a solar cell module according to the present invention and a method for manufacturing the same will be explained in detail with reference to the drawings. A solar cell module 1 according to the present invention is a crystalline silicon solar cell module including a single crystal type silicon photoelectric conversion element or a polycrystal type photoelectric conversion element as a photoelectric conversion element, or a thin-film silicon solar cell including a photoelectric conversion element in which a cell composed of amorphous silicon and a cell composed of microcrystal silicon or amorphous silicon germanium are laminated.

### [Solar Cell Module 1]

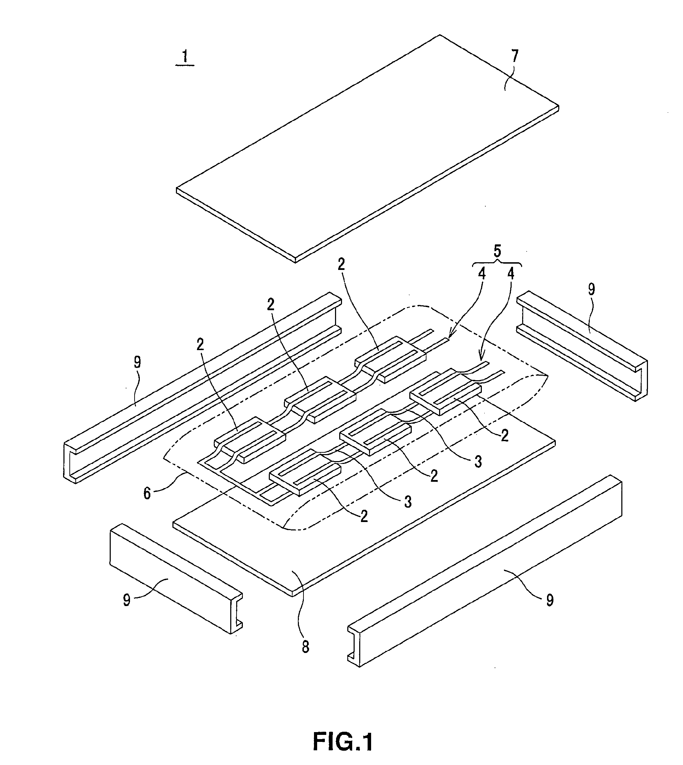

As shown in Fig. 1, the solar cell module 1 has a string 4 configured such that a plurality of solar cells 2 are connected in series by a tab lead 3 used as an interconnector, and includes a matrix 5 configured such that a plurality of the strings 4 are arranged. The solar cell module 1 is formed in such a manner that the matrix 5 is sandwiched with a sheet 6 of sealing adhesive, and laminated together with a front surface cover 7 provided at a side of a light incident surface and a back sheet 8 provider at a back surface side, and finally a metal flame 9 made of aluminum or the like is attached to the circumference thereof.

Examples of the sealing adhesive include a translucent sealing material, such as an ethylene-vinyl-alcohol (EVA) resin. Examples of the front surface cover 7 include a translucent material, such as glass or translucent plastics. Examples of the back sheet 8 include a laminated material configured such that glass or aluminum foil is sandwiched with a resin film.

### [Solar Cell 2]

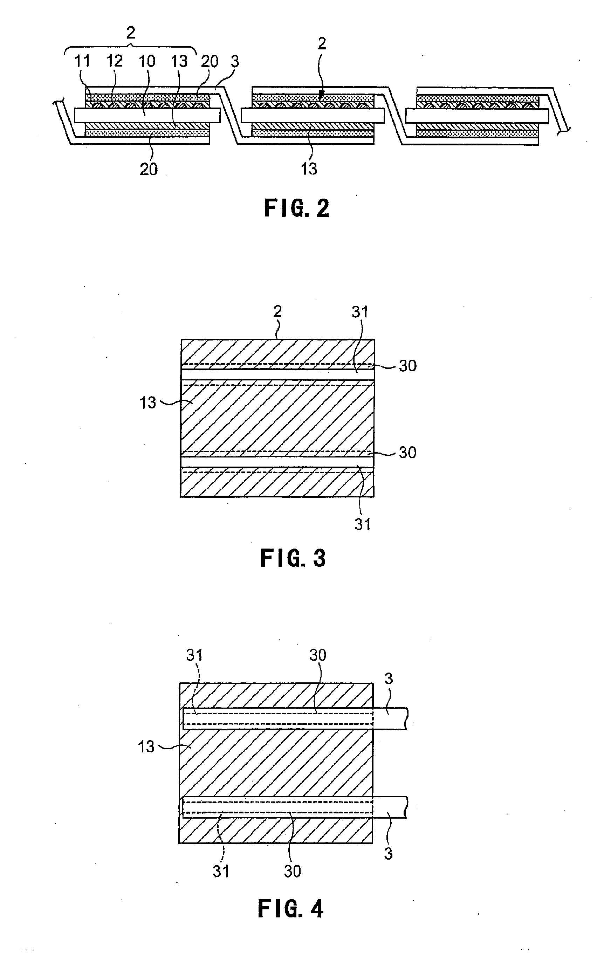

As shown in Fig. 2, each of the solar cells 2 of the solar cell module has a photoelectric conversion element 10 composed of a silicon substrate. The photoelectric conversion element 10 is configured such that, at a side of a light incident surface, a bus bar electrode 11 as a front surface electrode and a finger electrode 12 as a collector electrode which is formed in a direction approximately perpendicular to the bus bar electrode 11 are provided. In the photoelectric conversion element 10, an Al back surface electrode 13 made of aluminum is also provided at a side of a back surface opposed to the light incident surface.

A bus bar electrode 11 on a front surface of a solar cell 2 and an Al back surface electrode 13 of another solar cell 2 adjoining said solar cell 2 are electrically connected by a tab lead 3, whereby a string 4 in which the solar cells 2 are connected in series is constituted. Each of the connections between the tab lead 3 and the bus bar electrode 11 and between the tab lead 3 and the Al back surface electrode 13 is performed via the electroconductive adhesive film 20.

As the tab lead 3, a tab lead which has been used for conventional solar cell modules may be used. For example, the tab lead 3 is formed in such a manner that a ribbon-shaped copper foil having a thickness of 50 to 300 µm is used and plated with gold, silver, tin, solder, or the like, if needed.

The bus bar electrode 11 is formed by applying Ag paste and heating. The bus bar electrode 11 formed on the light incident surface of the solar cell 2 is formed, for example, in a line shape having a width of 1 mm in order to reduce an area in which incident light is interrupted and to minimize shadow loss. The number of the bus bar electrodes 11 is suitably determined in consideration of the size of the solar cell 2 and the resistance.

By the same manner as in the bus bar electrode 11, the finger electrode 12 is formed over approximately the whole of the light incident surface of the solar cell 2 so as to intersect the bus bar electrode 11. Also, the finger electrode 12 is formed in such a manner that, for example, lines having a width of approximately 100 µm are arranged at predetermined intervals, for example, at intervals of 2 mm.

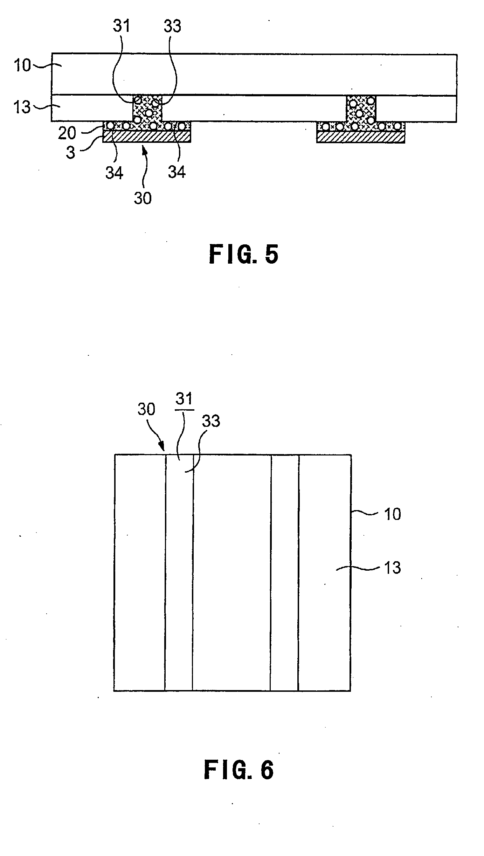

As shown in Fig. 3, the Al back surface electrode 13 is configured such that an electrode made of aluminum is formed on a back surface of the solar cell 2, for example, by screen-printing, sputtering, or the like. In the Al back surface electrode 13, an opening portion 31 is formed in a connecting portion 30 to the tab lead 3, and Si constituting the photoelectric conversion element 10 is exposed outward. Therefore, as shown in Fig. 4 and Fig. 5, in the solar cell 2, the electroconductive adhesive film 20 comes in contact with Si on the surface of the photoelectric conversion element 10 via the opening portion 31 of the Al back surface electrode 13.

### [Configuration 1]

As shown in Fig. 5, an opening portion 31 has a width smaller than those of a tab lead 3 and an electroconductive adhesive film 20. In a solar cell 2, the electroconductive adhesive film 20 and the tab lead 3 are laminated on a connecting portion 30, whereby the electroconductive adhesive film 20 is filled in the opening portion 31 and also laminated on a Al back surface electrode 13 at both sides of the opening portion 31.

Thus, in the solar cell 2, an inside of the opening portion 31 becomes a bonding portion 33 in which the electroconductive adhesive film 20 and Si exposed outward via the opening portion 31 are firmly bonded, while a circumference of the opening portion 31 becomes an electrically connecting portion 34 in which the Al back surface electrode 13 and the tab lead 3 are electrically connected.

Thus, in the solar cell 2, for the connection between the tab lead 3 and the Al back surface electrode 13 by using the electroconductive adhesive film 20, the opening portion 31 is formed in the connecting portion 30 to the tab lead 3 in the Al back surface electrode 13, whereby electrical connection can be realized in an Al portion, and connection strength can be secured in a Si portion exposed via the opening portion 31.

In the solar cell 2, by providing the opening portion 31 in the connecting portion 30, pressure at the time of pressurization concentrates on an area in the connecting portion 30 other than the opening portion 31. Therefore, in the solar cell 2, even in the case where a cell substrate is formed using an ultra-thin silicon wafer, the tab lead 3 can be connected to the Al back surface electrode 13 by hot-pressing at a low pressure by using the electroconductive adhesive film 20, and, without risk of breakage of the cell, connection strength of the tab lead 3 and the Al back surface electrode 13 can be secured. Furthermore, in the solar cell 2, it is not necessary to provide an Ag electrode on the back surface, whereby lower cost, reduction in the number of manufacturing man-hours, and the like can be achieved.

As shown in Fig. 6, in the solar cell 2, the connecting portion 30 in which the tab lead 3 is connected by the electroconductive adhesive film 20 is linearly secured, and the opening portion 31 is formed to be linearly opened over a longitudinal direction of the connecting portion 30.

In the solar cell 2, by providing the opening portion 31 linearly formed along with the connecting portion 30, an adhesive area between a Si surface and the electroconductive adhesive film 20 increases, whereby an adhesive property between the tab lead 3 and the Al back surface electrode 13 can be improved.

### [Configuration 2]

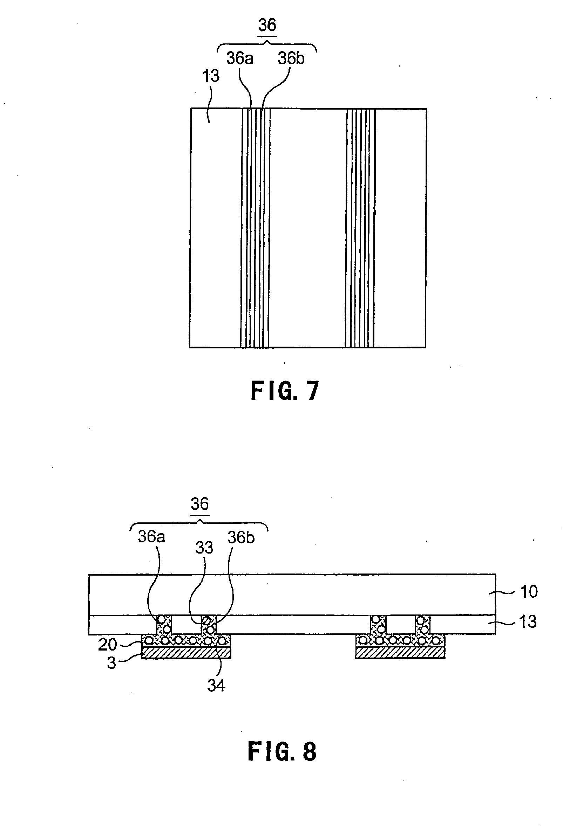

As shown in Fig. 7 and Fig. 8, in a solar cell 2, an opening portion 36 may be formed to be linearly opened over a longitudinal direction of a connecting portion 30 and also have a striped pattern obtained by arranging a plurality of narrower opening portions in parallel in a width direction. In each of opening portions 36a, 36b, and the like, each being arranged in parallel in a width direction of the connecting portion 30, a portion in which a Si surface of the solar cell 2 is exposed and directly bonded to the electroconductive adhesive film 20 becomes a bonding portion 33, while both sides of each of the opening portions 36a, 36b, and the like become an electrically connecting portion 34 in which the Al back surface electrode 13 and the tab lead 3 are electrically connected. Also, the opening portion 36 is formed so that a total width in a direction that each of the opening portions 36a, 36b, and the like is arranged in parallel is narrower than a width of the tab lead 3 and than a width of the electroconductive adhesive film 20. According to this opening portion 36, a contact area between a Si surface and the electroconductive adhesive film 20 is dispersed in a width direction, and also a contact area of the tab lead 3 and the Al back surface electrode 13 is larger than that in the case of the opening portion 31, and therefore power generation efficiency can be improved while adhesive property to the connecting portion 30 is maintained.

### [Configuration 3]

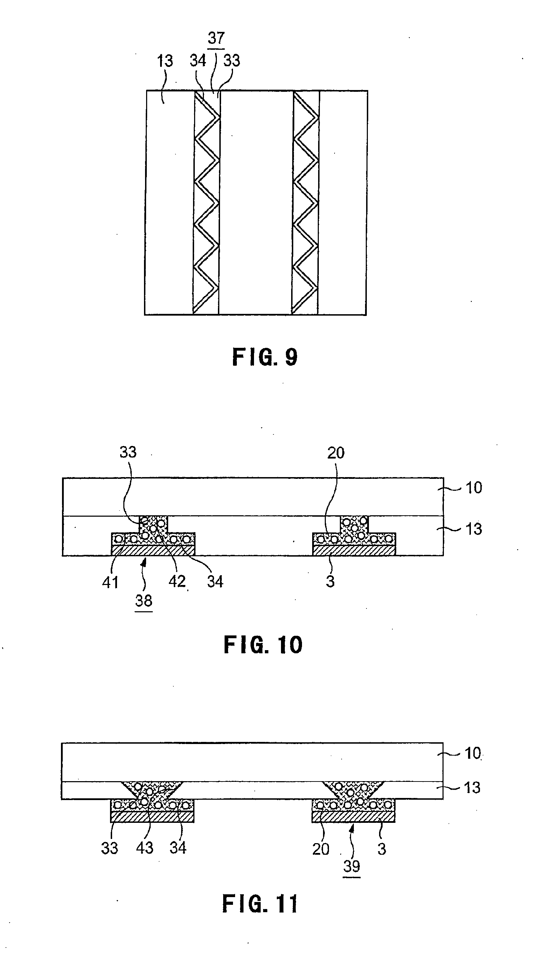

As shown in Fig. 9, in a solar cell 2, an opening portion 37 may be formed to be linearly opened over a longitudinal direction of the connecting portion 30 and also have an electrically connecting portion 34 formed in a zigzag pattern along a longitudinal direction of the connecting portion 30. In the opening portion 37, a portion in which an electrically connecting portion 34 is not formed over a longitudinal direction of the connecting portion 30 becomes a bonding portion 33 in which a Si substrate of the solar cell 2 is exposed, while an Al electrode portion which covers a Si surface and is formed in a zigzag pattern at both sides of the bonding portion 33 and at an inside of the connecting portion 30 becomes the electrically connecting portion 34 which is electrically connected to a tab lead 3. Also according to the opening portion 37, a contact area of the tab lead 3 and an Al back surface electrode 13 is larger than that in the case of the opening portion 31, and therefore power generation efficiency can be improved while an adhesive property to the connecting portion 30 is maintained.

### [Configuration 4]

As shown in Fig. 10, in a solar cell 2, an opening portion 38 may be formed to have a cross-sectional shape composed of a wide path portion 41 and a narrow path portion 42. The wide path portion 41 has the approximately same width as a width of a tab lead 3 and as a width of an electroconductive adhesive film 20, and has a depth obtained by combining a depth of the tab lead 3 and a depth of the electroconductive adhesive film 20. The tab lead 3 and the electroconductive adhesive film 20 are arranged inside the wide path portion 41 to be approximately flush with a back surface of the solar cell 2. Therefore, in the solar cell 2, the tab lead 3 does not protrude on an Al back surface electrode 13, whereby exfoliation and breakage of the tab lead 3 can be prevented and also design quality can be improved. Furthermore, in the solar cell 2, a contact area of the tab lead 3 and the Al back surface electrode 13 can be increased, whereby power generation efficiency can be improved.

The narrow path portion 42 is formed at the approximately center of a bottom surface of the wide path portion 41, wherein a Si surface is exposed outward and the electroconductive adhesive film 20 is filled thereinto. The cross-sectional shape of the opening portion 38 is composed of the wide path portion 41 having a width and a depth which are the approximately same as a width and a thickness of each of the tab lead 3 and the electroconductive adhesive film 20, and a narrow path portion 42, whereby, in the solar cell 2, the narrow path portion 42 becomes a connecting portion 33 in which the electroconductive adhesive film 20 and Si are firmly bonded, while the wide path portion 41 becomes an electrically connecting portion 34 in which the Al back surface electrode 13 and the tab lead 3 are electrically connected.

Thus, in the solar cell 2, in the connection between the tab lead 3 and the Al back surface electrode 13 by using the electroconductive adhesive film 20, connection strength can be secured in a Si portion exposed via the narrow path portion 42, while a contact area of the tab lead 3 and the Al electrode is increased, thereby improving power generation efficiency, and also, since the tab lead 3 does not protrude on the Al back surface electrode 13 and is approximately flush with the Al back surface electrode 13, exfoliation and breakage of the tab lead 3 can be prevented and also design quality can be improved.

### [Configuration 5]

As shown in Fig. 11, in a solar cell 2, an opening portion 39 may be formed to have a tapered portion 43 which reduces a path width outward. In the opening portion 39, a Si surface side of the solar cell 2 in which a path width is expanded by the tapered portion 43 becomes a bonding portion 33 in which an electroconductive adhesive film 20 and Si are firmly bonded, while an outward side in which a path width is reduced becomes an electrically connecting portion 34 in which the Al back surface electrode 13 and the tab lead 3 are electrically connected.

Thus, in the solar cell 2, by forming the opening portion 39 having the tapered portion 43 in which a path width is reduced in a direction of from the Si surface of the solar cell 2 to the outward side, a contact area of the electroconductive adhesive film 20 and the Si surface and a contact surface of the tab lead 3 and the Al back surface electrode 13 can be increased, respectively. Therefore, by providing the opening portion 39, in the solar cell 2, an adhesive property of the electroconductive adhesive film 20 and a Si surface is improved, and also an electrical conduction property between the tab lead 3 and the Al back surface electrode 13 is improved, whereby power generation efficiency can be improved.

### [Configuration 6]

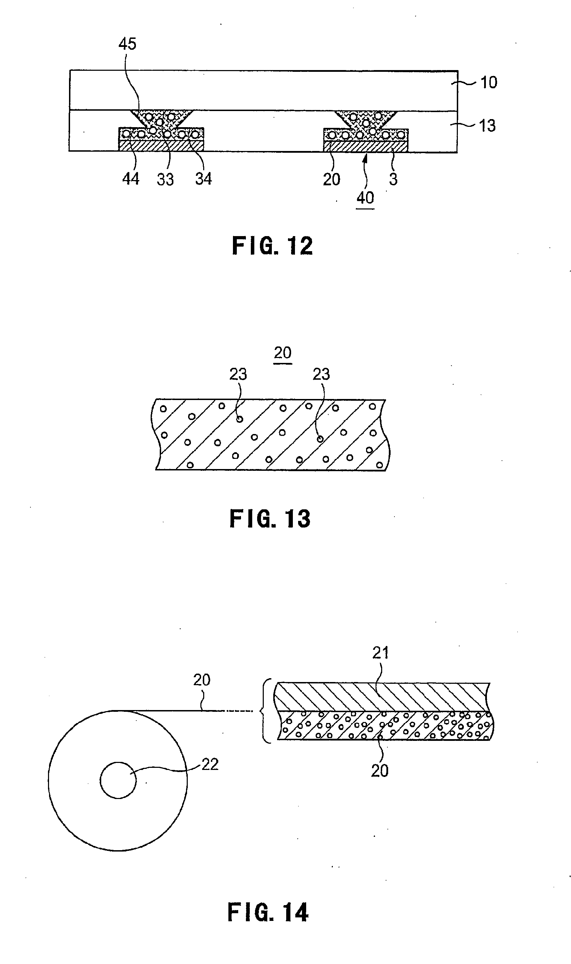

As shown in Fig. 12, in a solar cell 2, an opening portion 40 may be formed to have a cross-sectional shape composed of a wide path portion 44 and a tapered 45. As is the case with the above-mentioned wide path portion 41, the wide path portion 44 has the approximately same width as a width of a tab lead 3 and as a width of an electroconductive adhesive film 20, and has a depth obtained by combining a depth of the tab lead 3 and a depth of the electroconductive adhesive film 20. Accordingly, in the solar cell 2, the tab lead 3 and the electroconductive adhesive film 20 are arranged inside the wide path portion 44, whereby the tab lead 3 is approximately flush with a back surface of the solar cell 2 and a contact area of the tab lead 3 and an Al back surface electrode 13 is increased. Thus, in the solar cell 2, the tab lead 3 does not protrude on the Al back surface electrode 13, whereby exfoliation and breakage of the tab lead 3 can be prevented and also design quality can be improved, and furthermore, power generation efficiency can be improved.

As is the case with the above-mentioned tapered portion 43, a tapered portion 45 has a shape in which a path width is reduced in a direction of from a Si surface of the solar cell 2 to an outward side. Accordingly, in the solar cell 2, a contact area of the electroconductive adhesive film 20 and the Si surface and a contact surface of the tab lead 3 and the Al back surface electrode 13 is increased, respectively, whereby an adhesive property of the electroconductive adhesive film 20 and the Si surface is improved, and also an electrical conduction property between the tab lead 3 and the Al back surface electrode 13 is improved, whereby power generation efficiency can be improved.

### [Electroconductive Adhesive Film 20]

As shown in Fig. 13, an electroconductive adhesive film 20 is a thermosetting binder resin layer containing a high density of conductive particles 23.

From a viewpoint of squeezing property, in the electroconductive adhesive film 20, a minimum melt viscosity of the binder resin is preferably 100 to 100000 Pa·s. When a minimum melt viscosity of the electroconductive adhesive film 20 is too low, the resin flows at the steps of from low compression bonding to curing, whereby a poor connection and a flash to a light incident surface are easily caused, and also a reduction in light receiving rate is caused. When a minimum melt viscosity is too high, a defect easily generates at the time of film pasting, and a bad influence is sometimes given to connection reliability. Note that a minimum melt viscosity can be measured by charging a rotational viscometer with a predetermined quantity of sample and raising a temperature at a predetermined heating rate.

The conductive particles 23 used for the electroconductive adhesive film 20 are not limited, and examples of the conductive particles 23 include metal particles, such as nickel, gold, and copper particles, resin particles plated with gold or the like; and resin particles plated with gold whose outermost layer is insulating-coated. Note that flat, flake-shaped metal particles are contained as the conductive particles 23, whereby the number of the conductive particles 23 which overlap mutually is increased and good electrical connection reliability can be secured.

A viscosity of the electroconductive adhesive film 20 at around normal temperature is preferably 10 to 10000 kPa·s, more preferably 10 to 5000 kPa·s. When a viscosity of the electroconductive adhesive film 20 is in a range of 10 to 10000 kPa·s, in the case where the electroconductive adhesive film 20 is a tape-shaped reel roll, a so-called flash can be prevented and a predetermined tackiness can be maintained.

A composition of the binder resin layer of the electroconductive adhesive film 20 is not particularly limited as long as the above-mentioned characteristics are not reduced, but a film forming resin, a liquid epoxy resin, a latent curing agent, and a silane coupling agent are more preferably contained.

The film forming resin is equivalent to a high molecular weight resin having an average molecular weight of not less than 10000, and, from a viewpoint of film formation property, preferably has an average molecular weight of approximately 10000 to 80000. Examples of the film forming resin include various resins, such as an epoxy resin, a modified epoxy resin, a urethane resin, and a phenoxy resin. Among these, from viewpoints of film formation state, connection reliability, and the like, a phenoxy resin is suitably used.

The liquid epoxy resin is not particularly limited as long as having flowability at normal temperature, and all kinds of commercial epoxy resins can be used as the liquid epoxy resin. Specific examples of such epoxy resin include a naphthalene type epoxy resin, a biphenyl type epoxy resin, a phenol novolak type epoxy resin, a bisphenol type epoxy resin, a stilbene type epoxy resin, a triphenolmethane type epoxy resin, a phenol aralkyl type epoxy resin, a naphthol type epoxy resin, a dicyclopentadiene type epoxy resin, and a triphenylmethane type epoxy resin. These may be used alone, or two or more kinds of these may be used in combination. Furthermore, these may be used suitably in combination with other organic resins, such as an acrylate resin.

As the latent curing agent, various curing agents, such as a heat curing agent and a UV curing agent, may be used. The latent curing agent usually does not react, but is activated due to a trigger to start a reaction. Examples of the trigger include heat, light, and pressurization, and it can be chosen depending on the usage. In the case of using a liquid epoxy resin, a latent curing agent composed of imidazole, amine, a sulfonium salt, or an onium sallt may be used.

As the silane coupling agent, an epoxy type, an amino type, a mercaptosulfide type, a ureido type silane coupling agent, or the like may be used. Among these, an epoxy type silane coupling agent is preferably used in the present embodiment. In this way, an adhesive property at the interface between an organic material and an inorganic material can be improved.

As another additive composite, an inorganic filler is preferably contained. By making an inorganic filler contained, the flowability of the resin layer at the time of compression bonding can be adjusted, whereby a particle capture rate can be improved. As the inorganic filler, silica, talc, titanium oxide, calcium carbonate, magnesium oxide, or the like may be used, and a type of the inorganic filler is not particularly limited.

Fig. 14 is a schematic diagram showing an example of a product configuration of the electroconductive adhesive film 20. This electroconductive adhesive film 20 is obtained in such a manner that a binder resin layer is laminated on a release base material 21, and formed into a tape shape. This tape-shaped electroconductive adhesive film is rolled and laminated on a reel 22 so as to make the release base material 21 arranged at an outer periphery side. The release base material 21 is not particularly limited, and PET (PolyEthylene Terephthalate), OPP (Oriented Polypropylene), PMP (Poly-4-methlpentene-1), PTFE (Polytetrafluoroethylene), or the like may be used. The electroconductive adhesive film 20 may be configured to have a transparent cover film on a binder resin layer.

In this case, the above-mentioned tab lead 3 may be used as the cover film pasted on a binder resin layer. Thus, by laminating and integrating the tab lead 3 and the electroconductive adhesive film 20 beforehand, at the time of actual use, the release base material 21 is made to be released, and a binder resin layer of the electroconductive adhesive film 20 is pasted on a bus bar electrode 11 or a connecting portion 30 of an Al back surface electrode 13, whereby connection of the tab lead 3 to each of the electrodes 11 and 13, respectively, can be achieved.

Note that the electroconductive adhesive film 20 is not limited to have a reel shape, and may have a rectangular shape.

As shown in Fig. 14, in the case where the electroconductive adhesive film 20 is rolled around a reel and supplied as a reel product, when a viscosity of the electroconductive adhesive film 20 is in a range of 10 to 10000 kPa·s, the electroconductive adhesive film 20 can be prevented from being deformed and a predetermined size can be maintained. Also when the electroconductive adhesive film 20 has a rectangular shape and two or more sheets thereof are laminated, deformation can be prevented and a predetermined size can be maintained.

The above-mentioned electroconductive adhesive film 20 is obtained in a such manner that conductive particles 23, a film forming resin, a liquid epoxy resin, a latent curing agent, and a silane coupling agent are made to be dissolved in a solvent. As the solvent, toluene, ethyl acetate, or the like, or a mixed solvent of these may be used. A solution for resin forming obtained by the above-mentioned dissolution is applied on a release sheet, and a solvent is volatilized, whereby the electroconductive adhesive film 20 is obtained.

The solar cell 2 is obtained in such a manner that Ag paste is applied to a front surface of a photoelectric conversion element 10 and burned to form a finger electrode 12 and a bus bar electrode 11, while, on a back surface, an Al back surface electrode 13 having an opening portion 31, 36 to 40 in a connecting portion 30 to the tab lead 3 is formed by Al screen printing or the like.

Then, electroconductive adhesive films 20 are pasted to the bus bar electrode 11 on a front surface of the photoelectric conversion element 10 and to the connecting portion 30 on a back surface of the photoelectric conversion element 10, and a tab lead 3 is arranged on the electroconductive adhesive film 20. This lamination of the electroconductive adhesive film 20 and the tab lead 3 may be performed in such a manner that a film in which a binder resin layer of the electroconductive adhesive film 20 is formed on one surface of the tab lead 3 is pasted on the bus bar electrode 11 and the connecting portion 30.

Next, the tab lead 3 is hot-pressed from above at a predetermined pressure, whereby the tab lead 3 is electrically connected to each of the bus bar electrode 11 and the Al back surface electrode 13, respectively. At this time, a binder resin of the electroconductive adhesive film 20 has a good adhesive property to the bus bar electrode 11 formed of Ag paste, whereby the tab lead 3 is mechanically firmly connected to the bus bar electrode 11. Also, a binder resin of the electroconductive adhesive film 20 has a good adhesive property to a Si surface exposed from the opening portion 31, 36 to 40 formed in the connecting portion 30 of the Al back surface electrode 13, whereby the tab lead 3 is mechanically firmly connected to the Al back surface electrode 13 in the opening portion 31, 36 to 40, while being electrically connected in other Al portions. Furthermore, a pressure at the time of pressurization concentrates on an area other than the opening portion 31, 36 to 40 of the connecting portion 30, whereby the tab lead 3 is firmly connected also to the area other than the opening portion 31, 36 to 40 of the connecting portion 30 even at a low pressure.

Note that, in the present invention, the tab lead 3 may be connected to each of the electrodes 11 and 13, respectively, also by applying a pasty electroconductive adhesive agent other than by using the electroconductive adhesive film 20. In this case, a melt viscosity which is a viscosity at 25 degrees C measured by a cone-plate type viscometer is preferably 50 to 200 Pa·s, more preferably 50 to 150 Pa·s.

Furthermore, the bus bar electrode 11 does not necessarily need to be provided in the solar cell 2. In this case, in the solar cell 2, a current of the finger electrode 12 is collected by the tab lead 3 intersecting the finger electrode 12.

Note that, in the solar cell 2, an opening portion may be formed at a connecting portion to the tab lead 3 formed at a front surface side of the solar cell 2, and also in this case, connection strength can be secured at a low pressure.

### <Examples>

Next, there will be described Examples in each of which an adhesive property and a power generation efficiency of a solar cell 2 according to the present invention (dimension: 15.6 cm × 15.6 cm, thickness: 180 µm) were measured. In Example 1, the opening portion 31 (dimension of the opening portion: 1.5 mm × 15.6 cm, depth: 30 µm) was formed to be linearly opened over a longitudinal direction of a connecting portion 30, and a tab lead 3 was hot-pressed (180 degrees C, 15 seconds, 1 MPa) via an electroconductive adhesive film 20 by a heater head to be bonded. In Example 2, the opening portion 36 in which a plurality of narrower opening portions were arranged in parallel to be striped (dimension of each opening portion 36: 1.5 mm × 15.6 cm, depth: 40 µm, interval between the opening portions 36: 0.3 mm) was formed, and a tab lead 3 was hot-pressed (180 degrees C, 15 seconds, 1 MPa) via an electroconductive adhesive film 20 by a heater head to be bonded.

In Comparative Example 1, without providing an opening portion in a connecting portion to a tab lead, the tab lead was directly hot-pressed on an Al back surface electrode via an electroconductive adhesive film 20 to be bonded thereto. In Comparative Example 2, without providing an opening portion in a connecting portion to a tab lead, an Ag electrode was formed by printing and drying Ag paste, and a tab lead 3 was hot-pressed on this Ag electrode via an electroconductive adhesive film 20 to be bonded thereto. In Comparative Example 3, without providing an opening portion in a connecting portion to a tab lead, an Ag electrode was formed by printing and drying Ag paste, and a solder tab lead was hot-pressed on this Ag electrode to be bonded thereto.

An adhesive property was obtained by measuring the 90-degree peel strength (N/cm). A power generation efficiency was obtained by measuring a power generation efficiency before tab lead connection (%) and a power generation efficiency after tab lead connection (%), using a simulator. Table 1 shows the measurement results.

**[Table 1]**

| | | Example 1 | Example 2 | Comparative Example 1 | Comparative Example 2 | Comparative Example 3 |
|---|---|---|---|---|---|---|
| Connecting material | | Electroconductive adhesive film | Electroconductive adhesive film | Electroconductive adhesive film | Electroconductive adhesive film | Solder |
| Adherend | | Si substrate | Si substrate + Al electrode | Al electrode | Ag electrode | Ag electrode |
| Adhesive property (N/cm) | | 22 | 18 | 4 | 20 | 25 |
| Power generation efficiency (%) | Single cell | 15.88 | 15.84 | 15.79 | 15.81 | 15.74 |
| | After TAB lead connection | 15.80 | 15.77 | 15.70 | 15.74 | 15.67 |

As shown in Table 1, in Comparative Example 1, the adhesive property between the Al back surface electrode and the electroconductive adhesive film 20 was not good, whereby the adhesive property of the tab lead was decreased.
On the other hand, in each of Example 1 and Example 2, the adhesive property and the power generation efficiency were equivalent to those in each of Comparative Example 2 and Comparative Example 3, in each of which an Ag electrode was formed. In other words, in each of Example 1 and Example 2, an Ag electrode does not have to be formed in an Al back surface electrode, whereby, without procurement and printing and drying processes of Ag paste, a solar cell 2 having an adhesive property and a power generation efficiency equivalent to those of conventional solar cells can be obtained.

### Reference Signs List

1...solar cell module, 2...solar cell, 3...tab lead, 4...string, 5...matrix, 6...sheet, 7...front surface cover, 8...back sheet, 9...metal flame, 10...photoelectric conversion element, 11...bus bar electrode, 12...finger electrode, 13...Al back surface electrode, 20...electroconductive adhesive film, 30...connecting portion, 31...opening portion, 33...bonding portion, 34...electrically connecting portion, 36 to 40...opening portion, 41, 44...wide path portion, 42...narrow path portion, and 43, 45...tapered portion.

## Claims

1. A solar cell module, comprising:
a plurality of silicon cell substrates, each being configured such that a front surface electrode is provided at a side of a light incident surface while an Al back surface electrode is provided on a back surface at a side opposite to the light incident surface;
a tab lead configured to connect the front surface electrode of one of the silicon cell substrates to the Al back surface electrode of another one of the silicon cell substrates which adjoins said one of said silicon cell substrates; and
an electroconductive adhesive layer configured to connect each of the front surface electrode and the Al back surface electrode to the tab lead, respectively,
wherein, in the Al back surface electrode, an opening portion to expose a silicon surface of the silicon cell substrate is formed in a connecting portion to the tab lead, the opening portion being provided to be narrower than the tab lead and than the electroconductive adhesive layer, and being linearly formed along with the connecting portion, and
the tab lead is bonded, via the electroconductive adhesive layer, to the silicon surface of the silicon cell substrate which is exposed via the opening portion, while is bonded also to the Al back surface electrode.

2. The solar cell module according to claim 1, wherein a plurality of the opening portions is opened in a width direction of the tab lead and the electroconductive adhesive layer.

3. The solar cell module according to claim 1, wherein the opening portion has a wide path portion and a narrow path portion formed inside said wide path portion.

4. The solar cell module according to claim 1, wherein the opening portion is formed to be cross-sectionally tapered such that a path width thereof is reduced outward.

5. The solar cell module according to claim 3, wherein the narrow path portion is formed to be cross-sectionally tapered such that a path width thereof is reduced outward.

6. The solar cell module according to any one of claim 1 to claim 5, wherein an electroconductive adhesive film is configured such that the tab lead and the electroconductive adhesive film are integrated beforehand.

7. The solar cell module according to claim 6, wherein the electroconductive adhesive layer is cured when heat-pressurized from above the tab lead.

8. The solar cell module according to any one of claim 1 to claim 7, wherein
the front surface electrode has a plurality of finger electrodes formed in parallel on the light incident surface, and a bus bar electrode intersecting said plurality of said finger electrodes; and
the tab lead is connected to the bus bar electrode provided on the light incident surface of the silicon cell substrate.

9. The solar cell module according to any one of claim 1 to claim 8, wherein the opening portion is formed also in a connecting portion to the tab lead in the front surface electrode.

10. The solar cell module according to any one of claim 1 to claim 9, the solar cell module being a crystalline silicon solar cell.

11. A method for manufacturing a solar cell module, wherein the solar cell module includes a plurality of silicon cell substrates, each being configured such that a front surface electrode is provided at a side of a light incident surface while an Al back surface electrode is provided on a back surface at a side opposite to the light incident surface; and the front surface electrode of one of the silicon cell substrates is connected to the Al back surface electrode of another one of the silicon cell substrates which adjoins said one of said silicon cell substrates, with a tab lead, via an electroconductive adhesive layer,
the method comprising the steps of:
laminating the electroconductive adhesive layer in a opening portion which is linearly provided in a connecting portion to the tab lead in the Al back surface electrode along with said connecting portion, exposes a silicon surface of the silicon cell substrate, and is narrower than the tab lead and than the electroconductive adhesive layer; and
laminating one end of the tab lead on the electroconductive adhesive layer.

12. The method for manufacturing a solar cell module according to claim 11, wherein an electroconductive adhesive film is configured such that the tab lead and the electroconductive adhesive layer are integrated beforehand, and the step of laminating the electroconductive adhesive layer and the step of laminating the tab lead are performed simultaneously.

13. The method for manufacturing a solar cell module according to claim 12, wherein the electroconductive adhesive layer is cured by hot-pressed from above the tab lead.
